# EUROPÄISCHE PATENTSCHRIFT

(11) **EP 1 565 761 B1**
(45) Veröffentlichungstag und Bekanntmachung des Hinweises auf die Patenterteilung: **14.07.2021**
(21) Anmeldenummer: 03810391.7
(22) Anmeldetag: 21.08.2003
(51) Int. Cl.: G01R 35/00

(54) **VERFAHREN ZUM MESSEN DER STREUPARAMETER EINES MEHRTOR-MESSOBJEKTES MITTELS EINES MEHRTOR-NETZWERKANALYSATORS MIT NICHTSINUSF RMIGEN MESSSIGNALEN**
METHOD FOR MEASURING THE SCATTERING PARAMETERS OF A MULTIPORT TEST OBJECT BY MEANS OF A MULTIPORT NETWORK ANALYZER WITH NON-SINUSOIDAL MEASUREMENT SIGNALS
PROCEDE DE MESURE DES PARAMETRES DE DISPERSION D'UN OBJET DE MESURE MULTIPORT AU MOYEN D'UN ANALYSEUR DE RESEAU MULTIPORT A L'AIDE DE SIGNAUX DE MESURE NON SINUSOIDAUX

(30) Priorität: 05.11.2002 DE 10251551
(43) Veröffentlichungstag der Anmeldung: 24.08.2005
(73) Patentinhaber: Rohde & Schwarz GmbH & Co. KG, 81671 München (DE)
(72) Erfinder: MINIHOLD, Roland, 80639 München (DE); WEISS, Martin, 83607 Holzkirchen (DE); BEDNORZ, Thilo, 85435 Erding (DE); SIMON, Hans, Joachim, 82515 Wolfratshausen (DE); WINTER, Albert, 85661 Forstinning (DE)
(74) Vertreter: Körfer, Thomas
(86) Internationale Anmeldenummer: PCT/EP2003/009304
(87) Internationale Veröffentlichungsnummer: WO 2004/042415

(56) Entgegenhaltungen:
- WO-A-01/27648
- DE-A- 10 022 853
- US-A1- 2001 004 729

## Beschreibung

Die Erfindung betrifft ein Verfahren laut Oberbegriff des Hauptanspruches.

Die Eigenschaften von elektrischen Ein- oder Mehrtor-Schaltungen sind durch deren Streuparameter bestimmt. Diese Streuparameter sind Quotienten aus einlaufenden und auslaufenden Wellengrößen an den Toren der Schaltung, die durch skalare oder vektorielle Netzwerkanalysatoren gemessen werden können. Solche Netzwerkanalysatoren arbeiten üblicherweise mit sinusförmigen Meßsignalen. Zur Verringerung der Meßfehler, hervorgerufen durch die nicht idealen Eigenschaften der Meßtore, werden solche Netzwerkanalysatoren vor der eigentlichen Objektmessung kalibriert. Dazu werden an die Meßtore des Netzwerkanalysators verschiedene Kalibrierstandards angeschaltet, beispielsweise Leerlauf, Durchgang, Abschluß oder Kurzschluß. Aus diesen Kalibriermessungen werden Fehlerkorrekturwerte ermittelt, die dann bei der anschließenden Objektmessung entsprechend berücksichtigt werden. Kalibrierte Netzwerkanalysatoren besitzen daher eine sehr hohe Meßgenauigkeit. Die Art der Kalibriermethode hängt von der jeweiligen Meßaufgabe ab, es gibt hierzu eine Vielzahl von Möglichkeiten, die beispielsweise aus der DE 199 18 697 A1 oder der DE 195 27 730 A1 bekannt sind.

Um solche Messungen mit Netzwerkanalysatoren möglichst unter den gleichen Bedingungen durchzuführen wie im späteren Betrieb des Meßobjektes, ist es auch schon bekannt, zur Objektmessung ein nichtsinusförmiges Signal, beispielsweise ein digital moduliertes Signal, zu verwenden (WO 01/27648 A1 und US 2001/0004729 A1). Hierbei ist es ferner bekannt, die zunächst im Zeitbereich vorliegenden Meßsignale durch Fouriertransformation (DFT bzw. FFT) in den Frequenzbereich zu transformieren. Die Praxis hat jedoch gezeigt, daß selbst mit einem exakt kalibrierten Netzwerkanalysator bei Anwendung eines nichtsinusförmigen Meßsignals die Meßgenauigkeit stark abnimmt.

Es ist daher Aufgabe der Erfindung, ein Meßverfahren - - dieser Art aufzuzeigen, das auch bei Verwendung nichtsinusförmiger Meßsignale eine genaue Messung der Wellengrößen und damit Bestimmung der Streuparameter ermöglicht.

Diese Aufgabe wird ausgehend von einem Verfahren laut Oberbegriff des Hauptanspruches durch dessen kennzeichnende Merkmale gelöst. Vorteilhafte Weiterbildungen ergeben sich aus den Unteransprüchen.

Die Erfindung geht aus von der Erkenntnis, daß die Verschlechterung der Meßergebnisse bei Verwendung von nichtsinusförmigen Meßsignalen vor allem darauf zurückzuführen ist, daß die mit dem Netzwerkanalysator an den Toren des Meßobjektes gemessenen Wellengrößen in Folge von Laufzeitunterschieden im Meßaufbau und im Meßobjekt selbst zeitlich versetzt sind und die daraus resultierenden Fehler auch nicht durch Fehlerkorrekturwerte ausgeglichen werden können. Gemäß der Erfindung werden daher vor der eigentlichen Berechnung der Streuparameter die Zeitversätze zwischen den nichtsinusförmigen Meßsignalen in den Meßkanälen des Netzwerkanalysators, die den an den Toren des Meßobjekts gemessenen Wellengrößen entsprechen, berechnet. Aus diesen Zeitversätzen der Meßsignalabschnitte zueinander werden dann entsprechende Zeitkorrekturfaktoren abgeleitet, mit denen diese Zeitversätze so kompensiert werden, daß die Meßsignalabschnitte in den Meßkanälen des Netzwerkanalysators wieder ihre ursprüngliche zeitliche Übereinstimmung besitzen. Für die anschließende bekannte Systemfehlerkorrektur müssen die im Zeitbereich vorliegenden Meßsignale zunächst durch Fouriertransformation in den Frequenzbereich transformiert werden, so daß anschließend aus den einzelnen Spektrallinien der Meßsignale in den einzelnen Meßkanälen des Netzwerkanalysators die Streuparameter berechnet und mit den Systemfehlerkorrekturdaten korrigiert werden können. Die nach dem erfindungsgemäßen Verfahren ermittelten Zeitversätze zwischen den modulierten Meßsignalabschnitten untereinander müssen bei der abschließenden Fehlerkorrektur entsprechend berücksichtigt werden.

Das erfindungsgemäße Verfahren ist sowohl bei skalaren Netzwerkanalysatoren, bei denen nur die Wellenamplitude gemessen wird, als auch bei vektoriellen Netzwerkanalysatoren, bei denen die Wellengrößen nach Betrag und Phase gemessen werden, anwendbar, ebenso bei Netzwerkanalysatoren mit zwei, drei oder mehr Meßtoren, mit denen also Zwei-, Drei- oder Mehrtor-Meßobjekte vermessen werden können. Das erfindungsgemäße Verfahren ist außerdem bei allen Arten von nichtsinusförmigen Signalen anwendbar, beispielsweise bei Multiträger-Signalen oder modulierten Signalen. Es ist insbesondere von Vorteil für Meßverfahren, bei denen in das Meßobjekt digital modulierte Signale, z. B. WCDMA-Signale, eingespeist werden.

Die Zeitversätze zwischen den Meßsignalen können beispielsweise durch Faltung im Zeitbereich ermittelt werden. Als besonders einfach und vorteilhaft hat es sich jedoch erwiesen, wenn gemäß einer Weiterbildung der Erfindung die Zeitversätze durch eine Multiplikation im Frequenzbereich ermittelt werden, wie dies näher in der deutschen Offenlegungsschrift DE 100 22 853 A1 beschrieben ist.

Durch die erfindungsgemäße vorausgehende Zeitversatzkorrektur wird auch bei einer Messung mit nichtsinusförmigen Meßsignalen die gleiche Genauigkeit wie bei einer Messung mit rein sinusförmigen Meßsignalen erreicht.

Die Genauigkeit kann noch dadurch erhöht werden, daß auch für die Kalibrierung des Netzwerkanalysators ein entsprechend nichtsinusförmiges Signal benutzt wird und auch bereits bei den mit den Kalibrierstandards ermittelten Wellengrößen die sich durch- -das - - nichtsinusförmige Signal ergebenden Zeitversätze entsprechend korrigiert werden.

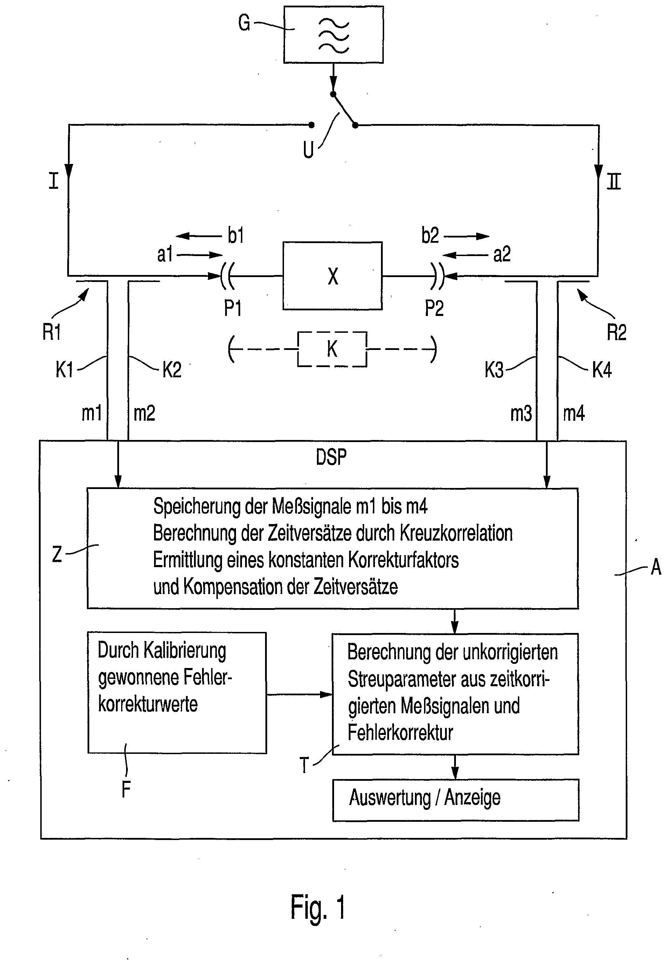

Die Erfindung wird im Folgenden anhand einer schematischen Zeichnung am Beispiels eines zwei Meßtore aufweisenden vektoriellen Netzwerkanalysators zum Messen der Streuparameter eines Zweitors näher beschrieben. Die einzige
- Fig. 1: zeigt einen Netzwerkanalysator zur Durchführung des erfindungsgemäßen Verfahrens.

Die Figur 1 zeigt das Prinzipschaltbild eines üblichen vektoriellen Netzwerkanalysators mit zwei Meßtoren P1 und P2, an die über einen Umschalter U wechselweise ein in der Frequenz sich änderndes hochfrequentes Meßsignal aus einem Generator G anschaltbar ist. Im einen Meßzweig I ist ein Richtkoppler R1 angeordnet, über welchen das der hinlaufenden Wellengröße a1 entsprechende Meßsignal m1 und das der rücklaufenden Wellengröße b1 entsprechende Meßsignal m2 gemessen wird. Im zweiten Meßzweig II wird über einen Richtkoppler R2 das der vom Meßobjekt X weglaufenden Welle b2 entsprechende Meßsignal m3 und das der auf das Meßobjekt X zulaufenden Welle a2 entsprechende Meßsignal m4 gemessen. Diese Meßsignale m1 bis m4 werden über Meßkanäle K1 bis K4 einer Auswerteinrichtung A des Netzwerkanalysators zugeführt und dort beispielsweise mittels eines Analog/Digital-Wandlers abgetastet und dann digital weiterverarbeitet und dazu vorzugsweise bis ins Basisband abgemischt.

Zur Kalibrierung des Netzwerkanalysators werden anstelle des Meßobjektes X nacheinander verschiedene Kalibrierstandards K an die beiden Meßtore P1 und P2 angeschaltet, beispielsweise nacheinander Leerlauf (open), Durchgang (through), Abschluß (match) oder Kurzschluß (short). Aus den mit diesen Kalibrierstandards K ermittelten Meßwerten werden in der z. B. als Signalprozessor ausgebildeten Auswerteinrichtung A in bekannter Weise Fehlerkorrekturwerte berechnet, die in einem Fehlerkorrekturwertspeicher F abgespeichert werden. Die Kalibrierung erfolgt vorzugsweise mit einem Sinus-Meßsignal. Der Generator G ist dazu beispielsweise ein Frequenzsynthesizer mit einem sinusförmigen Ausgangssignal.

Zur eigentlichen Objektmessung wird das zu vermessende Zweitor X, beispielsweise ein Hochfrequenzverstärker, mit seinem Ein- und Ausgang zwischen die beiden Meßtore P1 und P2 geschaltet und aus dem Generator G mit einem nichtsinusförmigen Ausgangssignal gespeist. Wenn der zu vermessende Verstärker X beispielsweise im späteren Betrieb zum Verstärken von WCDMA-Signalen eingesetzt wird, so wird vorzugsweise als Meßsignal ebenfalls ein entsprechend digital moduliertes Signal benutzt. Dieses modulierte Meßsignal wird periodisch in einer durch das Meßobjekt und die gewünschte Meßgenauigkeit vorbestimmten Meßzeit abwechselnd dem Meßtor P1 bzw. P2 zugeführt. Bei der Einspeisung des zeitlich begrenzten modulierten Meßsignals am Meßtor P1 entsteht beispielsweise im Meßkanal K1 ein der vorlaufenden Welle a1 entsprechendes moduliertes Meßsignal m1, außerdem ein der rücklaufenden Welle b1 entsprechendes moduliertes Meßsignal m2, das in Folge von Laufzeitunterschieden im Meßobjekt X einen gewissen Zeitversatz gegenüber dem Meßsignal m1 besitzt. Im Meßkanal K3 entsteht ein der übertragenen Welle b2 entsprechendes moduliertes Meßsignal m3, daß wiederum durch unterschiedliche Gruppenlaufzeiten sowohl gegenüber dem Meßsignal m2 als auch gegenüber dem Meßsignal m1 einen Zeitversatz aufweist. Gleiches wird bei Einspeisung des modulierten Meßsignals über den Meßzweig II und das Meßtor P2 festgestellt. Die so ermittelten Meßsignale m1 bis m4, die die gleiche Modulation und die gleiche Länge wie das eingespeiste modulierte Meßsignal des Generators G aufweisen und die je nach den Eigenschaften des Netzwerkanalysators und des jeweiligen Meßobjekts entsprechend gegeneinander zeitversetzt sind, werden in der Auswerteinheit Z zwischengespeichert. Dann werden diese gegenseitigen Zeitversätze der modulierten Meßsignalabschnitte ermittelt und zwar vorzugsweise gemäß einem Korrelationsverfahren nach der deutschen Offenlegungsschrift DE 100 22 853 A1. Dazu wird beispielsweise der Meßsignalabschnitt m1 als Bezugswert gewählt und zunächst der Zeitversatz des Meßsignals m2 gegenüber m1 bestimmt und dann der Zeitversatz von m3 gegenüber m1 usw., jeweils unter Anwendung des erwähnten Korrelationsverfahrens. Von diesen Zeitversätzen wird dann ein konstanter Korrekturfaktor abgeleitet, mit dem die Meßsignale so korrigiert werden, daß sie schließlich wieder zeitgleich sind und keinen gegenseitigen Zeitversatz mehr besitzen.

Beim Korrelationsverfahren gemäß DE 100 22 853 wird zunächst die Fouriertransformierte dieser Meßwerte ermittelt und daraus die konjugiert Komplexe berechnet. Durch Multiplikation der Fouriertransformierten des einen Meßsignals, z. B. m1, mit dem konjugiert Komplexen der Fouriertransformierten des anderen Meßsignals, z. B. m2, wird zwischen diesen beiden Meßsignalen ein komplexer Zeitterm berechnet, aus dessen Phasenanteil schließlich durch Regression (Berechnung der mittleren Steigung) der Zeitversatz zwischen den beiden Meßwerten berechnet wird. Aus diesen so ermittelten Zeitversätzen wird ein konstanter Korrekturfaktor abgeleitet, mit dem die Zeitversätze kompensiert werden.

Aus den so zeitkorrigierten Meßsignalen werden schließlich in der Rechenstufe T die gewünschten unkorrigierten Streuparameter berechnet und schließlich mit den Fehlerkorrekturdaten des Speichers F fehlerkorrigiert. Je nach Art der angewandten Fehlerkorrektur ist es erforderlich, die zunächst im Zeitbereich vorliegenden Meßsignale durch eine Fouriertransformation (DFT bzw. FFT) in den Frequenzbereich zu transformieren, so daß anschließend für alle dadurch entstehenden Spektrallinien des ursprünglichen modulierten Meßsignalabschnittes jeweils die Streuparameter berechnet werden können. Dabei müssen die bei der Zeitkorrektur angewandten Korrekturfaktoren erneut entsprechend berücksichtigt werden.

Zur Erhöhung der Dynamik und Genauigkeit kann es vorteilhaft sein, auch die Kalibrierung des Netzwerkanalysators mit einem nichtsinusförmigen Signalgenerator durchzuführen, also bereits bei der Kalibrierung nicht mehr ein Sinussignal, sondern beispielsweise ein digital moduliertes Signal, zu verwenden und hierbei bereits die beschriebene Zeitkorrektur durchzuführen.

## Patentansprüche

1. Verfahren zum Messen der Wellengrößen eines Mehrtor-Meßobjektes mittels eines Mehrtor-Netzwerkanalysators bei Einspeisung eines nichtsinusförmigen, insbesondere digital modulierten Meßsignals, wobei für den Netzwekanalysator in einem vorhergehenden Kalibrierverfahren Fehlerkorrekturwerte ermittelt werden, die bei der anschließenden Berechnung der Streuparameter aus den am Mehrtor-Meßobjekt gemessenen Wellengrößen entsprechend berücksichtigt werden,
**dadurch gekennzeichnet,**
**daß** zunächst die Zeitversätze zwischen den Meßsignalen in den Meßkanälen, die den an den Toren des Meßobjekts gemessenen Wellengrößen entsprechen, berechnet und kompensiert werden, dann aus diesen zeitkompensierten Meßsignalen unkorrigierte Streuparameter des Meßobjektes berechnet werden und schließlich diese Streuparameter mit den Fehlerkorrekturwerten korrigiert werden.

2. Verfahren nach Anspruch 1,
**dadurch gekennzeichnet,**
**daß** nach der Kompensation der Zeitversätze zwischen den Meßsignalen diese aus dem Zeitbereich in den Frequenzbereich transformiert werden und daraus dann die unkorrigierten Streuparameter berechnet und schließlich fehlerkorrigiert werden.

3. Verfahren nach Anspruch 1 oder 2,
**dadurch gekennzeichnet,**
**daß** die Berechnung der Zeitversätze zwischen den Meßsignalen durch Kreuzkorrelation erfolgt und dazu jeweils die Fouriertransformierte des einen Meßsignals jeweils mit der konjugiert Komplexen der Fouriertransformierten des anderen Meßsignals multipliziert wird und aus den Phasenanteilen der so ermittelten Zeittherme die jeweiligen Zeitversätze ermittelt werden.

4. Verfahren nach Anspruch 3,
**dadurch gekennzeichnet,**
**daß** aus der mittleren Steigung der ermittelten Phasenanteile ein konstanter Zeitkorrekturfaktor ermittelt wird, mit dem die Zeitversätze zwischen den Meßsignalen kompensiert werden.

5. Verfahren nach einem der vorhergehenden Ansprüche,
**dadurch gekennzeichnet,**
**daß** auch die Kalibrierung des Netzwerkanalysators mit einem nichtsinusförmigen Signal, insbesondere einem digital modulierten Signal, durchgeführt wird und auch hierbei vor der Ermittlung der Fehlerkorrekturwerte die Zeitversatzkorrektur zwischen den Meßsignalen nach dem Verfahren gemäß der vorhergehenden Ansprüche durchgeführt wird.

## Claims

1. A method for measuring the wavelength quantities of a multiport test object by means of a multiport network analyzer when supplying a non-sinusoidal, in particular digitally modulated measurement signal, wherein error correction values are determined for the network analyzer in a preceding calibrating method, which error correction values are correspondingly considered in the subsequent calculation of the scattering parameters from the wavelength quantities measured on the multiport test object,
**characterized in that**
the time offsets between the measurement signals in the measurement channels, which correspond to the wavelength quantities measured at the ports of the test object, are first calculated and compensated, then the uncorrected scattering parameters of the test object are calculated from these time-compensated measurement signals and finally these scattering parameters are corrected using the error correction values.

2. The method according to claim 1,
**characterized in that**
after the compensation of the time offsets between the measurement signals, they are transformed from the time range to the frequency range and then the uncorrected scattering parameters are calculated therefrom and finally error corrected.

3. The method according to claim 1 or 2,
**characterized in that**
the calculation of the time offsets between the measurement signals occurs by means of cross-correlation and to this end, in each case, the Fourier transform of the one measurement signal is in each case multiplied by the conjugated complexes of the Fourier transform of the other measurement signal and the respective time offsets are determined from the phase fractions of the time terms thus determined.

4. The method according to claim 3,
**characterized in that**
a constant time correction factor is determined from the mean slope of the determined phase fractions, with which the time offsets between the measurement signals are compensated.

5. The method according any of the foregoing claims,
**characterized in that** the calibration of the network analyzer is also carried out with a non-sinusoidal signal, in particular a digitally modulated signal, and in so doing, prior to the determination of the correction values the time offset correction is also carried out between the measurement signals in accordance with the method according to the foregoing claims.

## Revendications

1. Procédé pour mesurer les grandeurs d'onde d'un objet de mesure multiport au moyen d'un analyseur de réseau multiport lors de l'injection d'un signal de mesure non sinusoïdal, en particulier modulé de façon numérique, dans lequel pour l'analyseur de réseau des valeurs de correction d'erreur sont déterminées dans un procédé d'étalonnage précédent, qui sont prises en compte de manière correspondante lors du calcul subséquent des paramètres de dispersion à partir des grandeurs d'onde mesurées sur l'objet de mesure multiport,
**caractérisé en ce**
**que** les décalages temporels entre les signaux de mesure dans les canaux de mesure, qui correspondent aux grandeurs d'onde mesurées sur les ports de l'objet de mesure, sont tout d'abord calculés et compensés, ensuite des paramètres de dispersion de l'objet de mesure non corrigés sont calculés à partir de ces signaux de mesure compensés temporellement et enfin ces paramètres de dispersion sont corrigés avec les valeurs de correction d'erreur.

2. Procédé selon la revendication 1,
**caractérisé en ce**
**que**, après la compensation des décalages temporels entre les signaux de mesure, ceux-ci sont transformés à partir du domaine temporel dans le domaine fréquentiel et ensuite les paramètres de dispersion non corrigés sont calculés à partir de ceux-ci et enfin corrigés en termes d'erreurs.

3. Procédé selon la revendication 1 ou 2,
**caractérisé en ce**
**que** le calcul des décalages temporels entre les signaux de mesure s'effectue par corrélation croisée et à cet effet respectivement la transformée de Fourier d'un des signaux de mesure est multipliée respectivement par le complexe conjugué de la transformée de Fourier de l'autre signal de mesure et les décalages temporels respectifs sont déterminés à partir des parts de phase des termes temporels ainsi déterminés.

4. Procédé selon la revendication 3,
**caractérisé en ce**
**qu'**un facteur de correction temporelle constant, avec lequel les décalages temporels entre les signaux de mesure sont compensés, est déterminé à partir de la pente moyenne des parts de phase déterminées.

5. Procédé selon l'une quelconque des revendications précédentes,
**caractérisé en ce**
**que** l'étalonnage de l'analyseur de réseau est également réalisé avec un signal non sinusoïdal, en particulier un signal modulé de façon numérique, et également à cette occasion, avant la détermination des valeurs de correction d'erreur, la correction de décalage temporel entre les signaux de mesure est réalisée d'après le procédé selon l'une quelconque des revendications précédentes.
